# EUROPÄISCHE PATENTSCHRIFT

(11) **EP 0 408 867 B1**
(45) Veröffentlichungstag und Bekanntmachung des Hinweises auf die Patenterteilung: **02.03.1994**
(21) Anmeldenummer: 90109929.1
(22) Anmeldetag: 25.05.1990
(51) Int. Cl.: G01R 31/00

(54) **Vorrichtung zum Testen von an einer Gleichstromquelle angeschlossenen elek- trischen Verbrauchern eines Kraftfahrzeuges**
Device for testing electrical loads of a car which are connected with a direct current source
Dispositif pour l'essai de r'écepteurs électriques d'une automobile connectés à une source de courant continu

(30) Priorität: 15.07.1989 DE 3923545
(43) Veröffentlichungstag der Anmeldung: 23.01.1991
(73) Patentinhaber: MAN Nutzfahrzeuge Aktiengesellschaft, 80976 München (DE)
(72) Erfinder: Eisermann, Günter, D-8047 Karlsfeld (DE)

(56) Entgegenhaltungen:
- WO-A-87/07388
- FR-A- 2 623 948
- GB-A- 2 088 569
- GB-A- 2 168 211
- Taschenbuch für Elektromesstechnik, Siemens, 4.Auflage 1964, S.114

## Beschreibung

Die Erfindung betrifft eine Vorrichtung zum Testen von an einer Gleichstromquelle angeschlossenen elektrischen Verbrauchern eines Kraftfahrzeuges, mit den im Oberbegriff des Anspruchs 1 angegebenen Merkmalen.

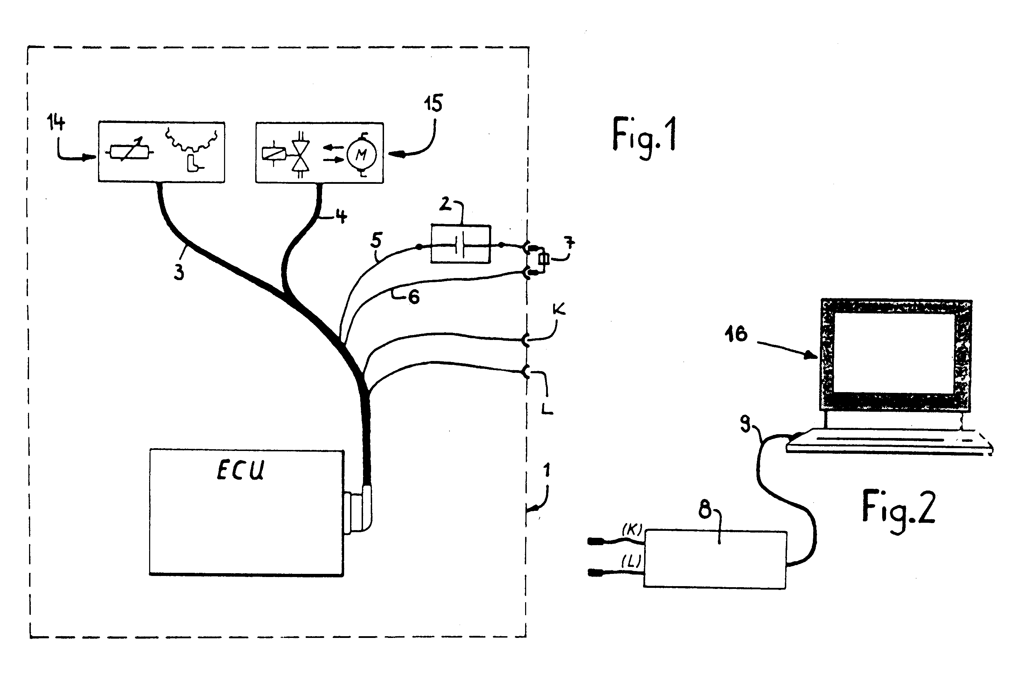

Die Erfindung geht aus von Diagnosesystemen für Straßenfahrzeuge gemäß DIN/ISO 9141, Ausgabe September 1987. Diese Norm legt die Anforderungen für einen Austausch digitaler Informationen zwischen elektronischen Steuereinheiten (ECUs - Elektronic-Control-Units) von Straßenfahrzeugen und geeigneten Diagnose-Prüfgeräten fest. Diese Kommunikation soll Kontrolle, Prüfung, Diagnose und Einstellung von Fahrzeugen, Systemen und elektronischen Steuereinheiten erleichtern. Fig. 1 zeigt in diesem Zusammenhang die Gegebenheiten an einem Kraftfahrzeug, Fig. 2 dagegen zeigt eine entsprechende Diagnoseeinheit. In Fig. 1 ist das Kraftfahrzeug durch einen gestrichelten Rahmen 1 symbolisiert. Als Teile dieses Kraftfahrzeuges sind, soweit sie für den vorliegenden Fall interessieren, mit 2 eine durch eine Batterie gebildete Gleichstromquelle, die elektrischen Verbraucher (Antriebsmotoren, Stellmotoren, Elektromagnete, Stellorgane und dergleichen) in ihrer Gesamtheit mit 15, die vorhandenen Meß-, Erfassungs- und sonstigen Feststellorgane in ihrer Gesamtheit mit 14 und eine elektronische Steuereinheit mit ECU bezeichnet. Die elektronische Steuereinheit ECU erhält entsprechende Signale von den Sensoren 14 über entsprechende Signalleitungen 3 zugeführt. Die Verbraucher 15 erhalten ihre Arbeitsbefehle von der elektronischen Steuereinheit ECU über entsprechende Steuerleitungen 4.

An der elektronischen Steuereinheit ECU ist außerdem die Gleichstromquelle 2 über entsprechende Anschlußleitungen 5, 6 angeschlossen. In die Anschlußleitung 6 ist zur Absicherung der Hauptleitung eine demontierbare Sicherung 7 eingesetzt. Außerdem hat die elektronische Steuereinheit ECU entsprechend den Erfordernissen der DIN/ISO 9141 entweder nur einen Kommunikationsanschluß K oder zwei Kommunikationsanschlüsse K, L, über welche die Diagnose- bzw. Testverbindung mit der Diagnose-Einheit 8, 16 für Testzwecke herstellbar ist. Die Diagnose-Einheit besteht generell aus einem Diagnosecomputer 16, bei dem es sich um ein in einer Werkstatt vorhandenes Gerät (z.B. PC) oder vom Wartungspersonal zum Einsatzort hin tragbares Gerät (sogenannter Porter) handeln kann, mit je nach Anwendungsfall einer Kommunikationsleitung (K) bzw. zwei Kommunikationsleitungen (K), (L) und, falls die elektronische Steuereinheit ECU und der Diagnosecomputer (16) nicht dem gleichen Datenübertragungssystem angehören, mit einem Interface-Adapter 8 mit serieller Schnittstelle 9 (z.B. RS 232). Gemäß Absatz 4.1 der DIN/ISO 9141 müssen elektronische Steuereinheiten ECU einen (K) oder zwei Kommunikationsanschlüsse (K, L) für die Kontrolle der Prüfung und der Diagnose aufweisen. Außerdem muß die Batteriespannung und die gemeinsame Rückleitung für das Diagnose-Prüfgerät entweder von der elektronischen Steuereinheit ECU oder vom Fahrzeug 1 bereitgestellt werden. Wenn die Leitungen K und L von zwei oder mehreren elektronischen Steuereinheiten ECUs zusammengeschaltet sind, wird das daraus gebildete System ein Bus-System genannt. Die Leitung K ist definiert als die Leitung, die die Information in serieller und digitaler Form von der elektronischen Steuereinheit ECU zum Diagnose-Computer 16 liefert. Die Leitung K darf auch bidirektional genutzt werden; in diesem Fall darf sie auch Befehle oder Daten vom Diagnose-Computer 16 zur elektronischen Steuereinheit ECU übertragen. Die Leitung K darf außerdem dazu benutzt werden, die serielle Kommunikation zu initialisieren. Die Leitung L ist definiert als unidirektionale Leitung vom Diagnose-Computer 16 zur elektronischen Steuereinheit ECU. Wenn diese vorhanden ist, darf sie dazu verwendet werden, die serielle Kommunikation zu initialisieren und/oder Befehle und/oder Daten zu übertragen. Aus dem Vorgenannten kann entnommen werden, daß nur die folgenden vier Anforderungen verwendet werden dürfen, da die Leitung K entweder uni- oder bidirektional und die Leitung L vorhanden oder nicht vorhanden sein darf:
1. Bidirektionale Leitung K mit unidirektionaler Leitung L.
2. Unidirektionale Leitung K mit unidirektionaler Leitung L.
3. Bidirektionale Leitung K ohne Leitung L.
4. Unidirektionale Leitung K ohne Leitung L.

In jedem der vier Fälle darf eine andere Initialisierung angewandt werden, d.h., alternativ zur Verwendung der Leitung K und L. Seite 4 der DIN/ISO 9141 zeigt verschiedene Anordnungen der Systeme auf und enthält Angaben über die Funktionen der Kommunikationsleitungen K und L. Unter Kapitel 4.2 (Seite 5) der DIN/ISO 9141 ist die prinzipielle Anordnung für einen Testfall zu finden.

Obschon diese Standardisierung der Test- bzw. Diagnoseverfahren, der entsprechenden Geräte und Vorkehrungen fahrzeugseitig an sich für den Normalfall genügen, ergibt sich dennoch folgendes Problem, das durch den Aufbau und die Funktion der elektronischen Steuereinheit ECU bedingt ist. Eine solche elektronische Steuereinheit ECU ist aufgrund der vorhandenen Hardware und einprogrammierten Software in der Lage, einen Selbsttest mit einer nicht flüchtigen Fehlerspeicherung und einer Feststellung der Fehlerhäufigkeit durchzuführen. Die elektronische Steuereinheit ECU ist aber nicht in der Lage, die elektrische Leistungsaufnahme der einzelnen elektrischen Verbraucher (15) zu erfassen. Das heißt, die elektronische Steuereinheit ECU kann nur nach Schwarz-Weiß-Methode das Funktionieren oder Nichtfunktionieren eines elektrischen Verbrauchers (15) feststellen. Gerade aber das Wissen um die "Qualität bzw. Größe" eines Schadens im betreffenden elektrischen Verbraucher bzw. die Art des Fehlers in dessen Funktion wäre sehr hilfreich für eine gezielte, richtige und schnelle Schadens- bzw. Mängelbehebung.

Es ist daher Aufgabe der Erfindung, eine Vorrichtung der eingangs definierten Art dahingehend zu verbessern, daß mit dieser beim Testen von an einer Gleichstromquelle angeschlossenen elektrischen Verbrauchern eines Kraftfahrzeuges Schäden bzw. Mängel oder Fehlfunktionen an solchen nach Methoden der Norm DIN/ISO 9141 getesteten elektrischen Verbrauchern sicher feststellbar und eindeutig definierbar sind.

Diese Aufgabe ist erfindungsgemäß durch eine Vorrichtung mit den im Anspruch 1 gekennzeichneten Merkmalen gelöst.

Vorteilhafte Einzelheiten bzw. Ausgestaltungen dieser Lösung sind in den Unteransprüchen gekennzeichnet.

Im Prinzip besteht die erfindungsgemäße Lösung darin, daß die Vorrichtung zum Testen über die gattungsgemäßen Mittel hinaus auch einen Meßwiderstand (Shunt) umfaßt, der nur für einen Test in den Strompfad zwischen Gleichstromquelle und elektrischen Verbrauchern des Fahrzeugs, und zwar nach vorheriger Entfernung der Fahrzeug-Hauptsicherung zwischen deren Klemmen eingeschaltet und nach Beendigung des Testvorganges wieder entfernt wird. Während eines Testes erzeugt dieser Meßwiderstand (Shunt) nach Aktivierung des zu testenden Verbrauchers durch den Diagnosecomputer der Vorrichtung einen von der Stromaufnahme des betreffenden Verbrauchers abhängigen Spannungsabfall. Dieser wird gemessen und in der Diagnoseeinheit mit einem verbraucherspezifischen Sollwert verglichen. Sofern sich durch diesen Vergleich eine Differenz ergibt, bewirkt deren Größe einen exakten Hinweis auf den konkret vorliegenden Schaden im Verbraucher bzw. Fehler in dessen Funktion, der visuell auf dem Bildschirm des Diagnosecomputers oder in gedruckter Form als Ausgabeprotokoll, z.B. in Form von _{"}Kurzschluß im.." oder _{"}Übergangswiderstand in Teil..." oder _{"}Totalausfall des..." oder _{"}Windungsschluß in Wicklung..." oder dergleichen Aussagen, aufgezeigt wird.

Der erfindungsgemäße Meßwiderstand (Shunt) stellt innerhalb der Vorrichtung ein relativ einfaches und billiges Zusatzbauteil dar, das preismäßig kaum ins Gewicht fällt, vom Ergebnis her gesehen jedoch sehr große Vorteile erbringt. Er kann als eigenständiges Bauteil oder mit dem Interface-Adapter, falls dieser Bestandteil der Vorrichtung ist, baulich vereinigt realisiert sein.

Des besseren Verständnisses und des besseren Vergleiches wegen sei erst nachfolgend auf den Stand der Technik eingegangen.

Aus der FR-A-2623948 ist eine Schaltungsanordnung zum Überwachen von mehreren parallelgeschalteten Leisfungsausgängen eines elektrischen Verbrauchers, genannt ist ein Motor eines Kraftfahrzeuges, bekannt, bei der alle Leistungsausgänge dieses Verbrauchers über einen gemeinsamen Meßwiderstand geführt sind. Dieser Meßwiderstand ist fester Bestandteil der Schaltungsanordnung. Diese wiederum ist fester Bestandteil des Fahrzeugs und sorgt bei Auftreten eines über den Spannungsabfall am Meßwiderstand erkannten Kurzschlusses an einem der Leistungsausgänge des elektrischen Verbrauchers für eine unmittelbare Abschaltung aller Leistungsausgänge desselben. Dieses bedeutet eine Stillsetzung dieses Verbrauchers als Ergebnis der permanenten Überwachung im Fehlfunktionsfall. Auch wenn die Auswertung der Überwachungsergebnisse durch einen Mikrocoumputer über einen Testmodus abläuft, so ist und bleibt dieser Bestandteil der fahrzeuginternen Schaltungsanordnung.

Aus der GB-A-2 088 569 schließlich geht ein Diagnosesystem hervor, das zu Überprüfungszwecken mit der elektronischen Steuereinheit eines Kraftfahrzeuges verbindbar ist und den Vorgaben der eingangs geschilderten Norm gehorcht.

Was die Verwendung eines Meßwiderstandes als solches zur Erzeugung präziser Meßergebnisse anbelangt, sei erwähnt, daß dieses dem Fachmann aus dem _{"}Siemens-Taschenbuch für Elektromeßtechnik, 1964, Seite 114" bekannt ist. Die dort als Nebenwiderstände benannten Meßwiderstände sind in den Leitungsweg zwischen zu messendem Verbraucher und Meßgerät einsetzbar.

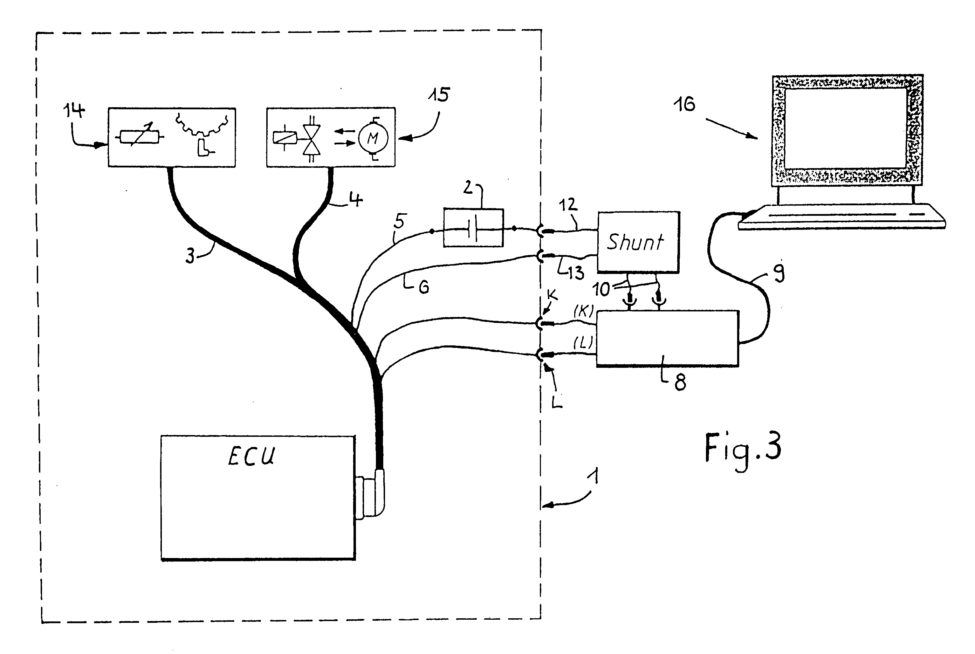

Nachstehend ist die erfindungsgemäße Lösung anhand der in den Figuren 3 bis 5 aufgezeigten Ausführungsbeispiele noch näher erläutert.

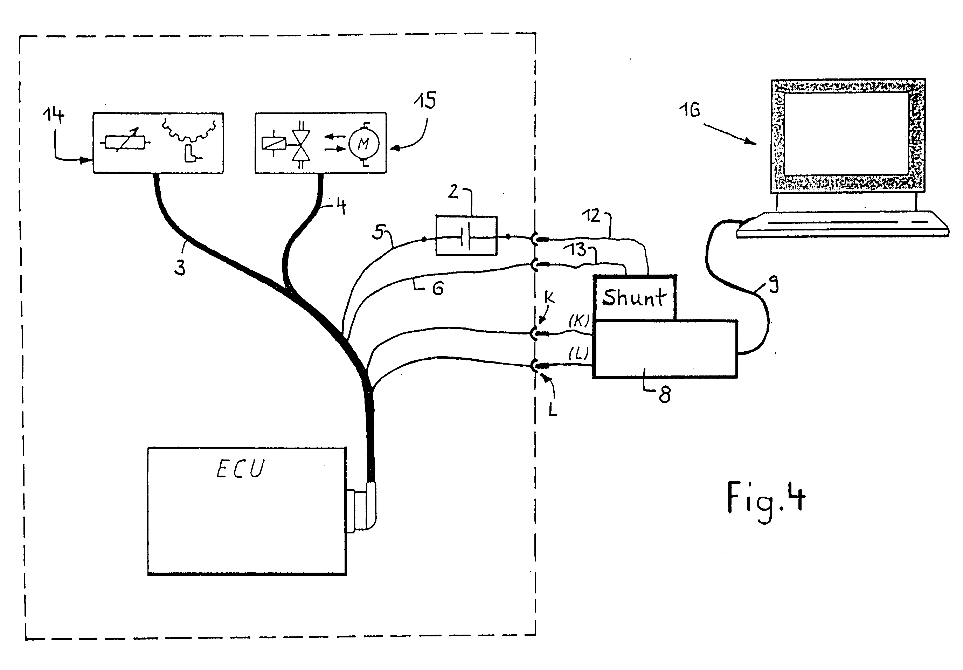

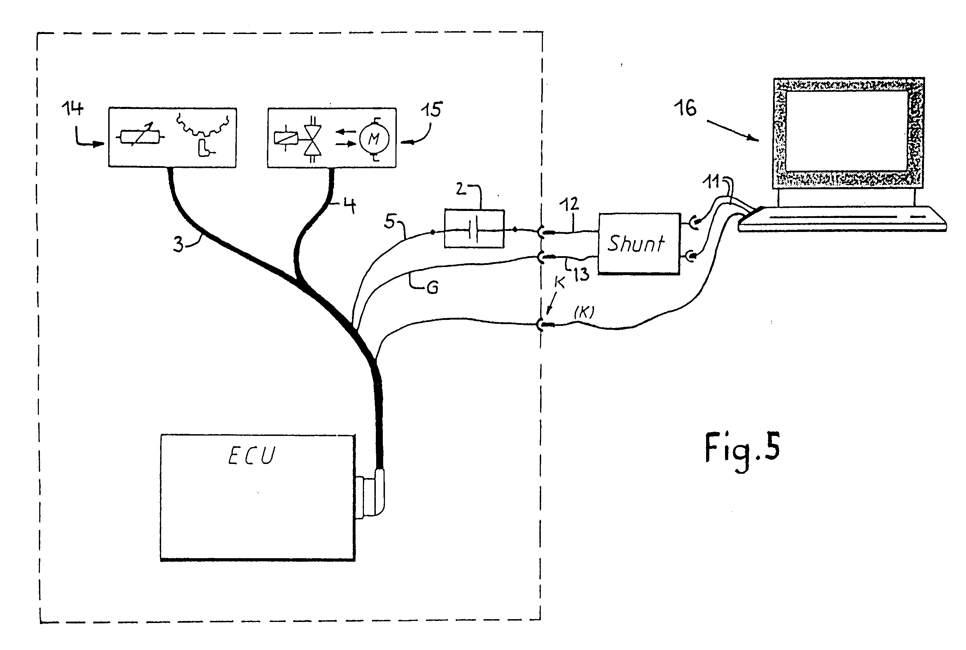

Fig. 3 zeigt die Diagnose-Einheit entsprechend Variante gemäß Fig. 2, also mit Diagnosecomputer 16 und Interface-Adapter 8, angeschlossen für einen Test an die Gegebenheiten eines Kraftfahrzeuges 1, wie in Fig. 1 dargestellt. Anstelle der Fahrzeug-Sicherung 7 wurde nach deren Entfernen mit deren Klemmen der erfindungsgemäße Meßwiderstand (Shunt) verbunden. Dieser Meßwiderstand (Shunt) zeichnet sich durch eine hohe Widerstandskonstanz und damit die Lieferung hochpräziser Meßwerte aus. Im Fall von Fig. 3 bildet der Meßwiderstand (Shunt) ein eigenständiges Bauteil, von dem die Meßwerte über entsprechende Signalleitungen 10 zum Interface-Adapter 8 übertragen und in letzterem ausgewertet werden. Im Fall gemäß Fig. 4 bildet der erfindungsgemäße Meßwiderstand (Shunt) mit dem Interface-Adapter 8 eine Bauteinheit, von der aus die erfaßten Meßwerte über nicht dargestellte Anschlüsse bzw. Kanäle zu einer im Interface-Adapter 8 gegebenen Auswert-Schaltung geleitet werden. In Fig. 5 ist jene Lösung gezeigt, bei der der Diagnose-Computer 16 dem gleichen System gehorcht wie die elektronische Steuereinheit ECU des Fahrzeugs 1, so daß in diesem Fall auf den Interface-Adapter 8 verzichtet werden kann und auch nur eine Datenübertragungsleitung (K) zwischen einem entsprechenden Anschluß K der elektronischen Steuereinheit ECU und dem Diagnose-Computer 16 notwendig ist. Der erfindungsgemäße Meßwiderstand (Shunt) überträgt die ermittelten Meßwerte in diesem Fall über Signalleitungen 11 direkt zum Diagnose-Computer 16.

Innerhalb des Diagnose-Computers 16 ist die Prüf-Software auf einem entsprechenden Träger, z.B. einer Diskette abgespeichert. Wenn in einem Testfall vom Diagnose-Computer 16 ein Befehl über die fahrzeuginterne elektronische Steuereinheit ECU für die Ansteuerung eines zu testenden Verbrauchers 15 an letzteren geleitet wird, dann fließt ein Strom von der Gleichstromquelle 2 über den erfindungsgemäßen Meßwiderstand (Shunt) zum getesteten Verbraucher 15. Am erfindungsgemäßen Meßwiderstand (Shunt) ergibt sich dabei ein von der Stromaufnahme des Verbrauchers 15 abhängiger Spannungsabfall, der zwischen den Anschlußklemmen 12, 13 gemessen und zur Auswertung an die Diagnose-Einheit weitergeleitet wird. Für diese Auswertung sind, wie bereits erwähnt, entweder im Interface-Adapter 8 oder im Diagnose-Computer 16 entsprechende Vorkehrungen vorhanden. Der am Meßwiderstand (Shunt) sich ergebende Spannungsabfall wird dabei mit einem verbraucherspezifischen Sollwert verglichen. Im Fall einer Differenz bewirkt dann deren Größe einen exakten Hinweis auf den konkret vorliegenden Schaden im getesteten elektrischen Verbraucher bzw. Fehler in dessen Funktion. Da das aus diesem Differenzwert unmittelbar hervorgehende Diagnose-Ergebnis dem den Test ausführenden Personal direkt visuell auf dem Bildschirm des Diagnose-Computers 16 oder in Form eines durch einen zugehörigen Drucker ausgedruckten Testprotokolls sichtbar gemacht wird, können entsprechend dem aufgezeigten Schaden bzw. Fehler direkt entsprechende Abhilfemaßnahmen ergriffen werden.

Der Ausbau eines mit einem Schaden oder Funktionsfehler behafteten elektrischen Verbrauchers zum Zwecke der exakten Feststellung des tatsächlichen Mangels, wie bisher notwendig, ist nach Einführung des erfindungsgemäßen Meßwiderstandes (Shunt) nicht mehr erforderlich. Vielmehr können kleinere Mängel gegebenenfalls auch am noch eingebauten elektrischen Verbraucher behoben werden.

## Patentansprüche

1. Vorrichtung zum Testen von an einer Gleichstromquelle (2) angeschlossenen elektrischen Verbrauchern (15) eines Kraftfahrzeuges (1), die ihre Arbeitsbefehle von einer elektronischen Steuereinheit (ECU) erhalten, wobei die Vorrichtung einen Diagnosecomputer (16) mit Bildschirm und gegebenenfalls einem Drucker zur Kenntlichmachung der Testergebnisse aufweist, in welchem Diagnosecomputer (16) eine Prüfsoftware auf entsprechendem Träger, z.B. Diskette, abgespeichert ist und wobei der Diagnosecomputer (16) für Testzwecke - soweit erforderlich-über einen Interface-Adapter (8) mit der elektronischen Steuereinheit (ECU) des Fahrzeugs verbindbar ist, dadurch gekennzeichnet, daß die Vorrichtung auch einen Meßwiderstand (Shunt) umfaßt, der nur für den Testfall in den Strompfad (5, 6) zwischen Gleichspannungsquelle (2) und elektrischen Verbrauchern (15) des Fahrzeugs einsetzbar, und zwar nach Entfernen der Fahrzeug-Hauptsicherung (7) mit den normalerweise für diese Hauptsicherung (7) vorgesehenen Klemmen verbindbar ist und - nach Aktivierung des zu testenden Verbrauchers durch den Diagnosecomputer (16) - einen von der Stromaufnahme des besagten Verbrauchers abhängigen Spannungsabfall erzeugt, der gemessen und in der aus Diagnosecomputer und - soweit erforderlich - aus dem Interface-Adapter bestehenden Diagnose-Einheit (8, 16) mit einem verbraucherspezifischen Sollwert verglichen wird, wobei im Falle einer Soll-Istwert-Differenz deren Größe einen exakten Hinweis auf den konkret vorliegenden Schaden im Verbraucher bzw. Fehler in dessen Funktion, wie zum Beispiel Kurzschluß, Übergangswiderstand, Totalausfall, Windungsschluß, als Testergebnis bewirkt.

2. Vorrichtung nach Anspruch 1, dadurch gekennzeichnet, daß der Meßwiderstand (Shunt) zur Erzielung hochpräziser Meßwerte auf eine hohe Widerstandskonstanz ausgelegt ist.

3. Vorrichtung nach einem der vorhergehenden Ansprüche, dadurch gekennzeichnet, daß der Meßwiderstand (Shunt) zusätzlich zu dem aus Diagnosecomputer (16) und dem erforderlichenfalls vorhandenen Interface-Adapter (8) gebildeten eigenständigen Bauteil ein weiteres eigenständiges Bauteil bildet.

4. Vorrichtung nach einem der Ansprüche 1 und 2, dadurch gekennzeichnet, daß dann, wenn ein Interface-Adapter (8) Bestandteil von ihr ist, dieser zusätzlich zu der vom Diagnosecomputer (16) gebildeten selbständigen Einheit eine weitere selbständige Einheit bildet, mit der der Meßwiderstand (Shunt) baulich vereinigt ist, wobei diese letztere Baueinheit außer den Anschlüssen (K, L) des Interface-Adapters (8) noch jene (12, 13) des Meßwiderstandes (Shunt) aufweist.

## Claims

1. A device for testing electrical loads (15) of a motor vehicle (1) which are connected to a direct current source (2) and which receive their operating commands from an electronic control unit (ECU), wherein the device has a diagnostic computer (16) with display screen and, if appropriate, a printer for visually indicating the test results, in which diagnostic computer (16) test software is stored on an appropriate carrier, e.g. floppy disc, and wherein for testing purposes the diagnostic computer (16) may be connected - if required - by way of an interface adapter (8) to the electronic control unit (ECU) of the vehicle, characterised in that the device also comprises a precision resistor (shunt) which may only be installed for the test case in the current path (5, 6) between the direct voltage source (2) and electrical loads (15) of the vehicle, and may only be connected, after the removal of the vehicle's main fuse (7), to the terminals normally provided for this main fuse (7), and - after activation of the load to be tested by the diagnostic computer (16) - produces a voltage drop dependent on the current consumption of the said load which is measured and compared in the diagnostic unit (8, 16), consisting of the diagnostic computer and - if required - the interface-adapter, with a desired value specific to the load, the value of which, in the event of a desired value-actual value difference, producing as the test result a precise indication of the defect actually present in the load or errors in its function such as, for example, short circuit, contact resistance, total failure, interturn short circuit.

2. A device according to claim 1, characterised in that the precision resistor (shunt) is rated at a high resistance constancy in order to obtain highly precise measured values.

3. A device according to one of the preceding claims, characterised in that in addition to the independent component composed of the diagnostic computer (16) and the interface-adapter (8) which is present if required, the precision resistor (shunt) forms a further independent component.

4. A device according to one of claims 1 and 2, characterised in that if an interface adapter (8) is a component part of the device, it forms, in addition to the independent unit composed of the diagnostic computer (16), a further independent unit with which the precision resistor (shunt) is structurally combined, this last-mentioned structural unit having, as well as the terminals (K, L) of the interface-adapter (8), also those (12, 13) of the precision resistor (shunt).

## Revendications

1. Dispositif pour tester des récepteurs électriques (15) raccordés à une source de courant continu (2) d'un véhicule à moteur (1), qui reçoivent leurs ordres de fonctionnement d'une unité électronique de commande (ECU), ce dispositif comportant un ordinateur de diagnostic (16) avec un écran et le cas échéant une imprimante pour faire connaître les résultats du test, ordinateur de diagnostic (16) dans lequel un logiciel d'examen est mis en mémoire sur un support correspondant tel que par exemple une disquette, et l'ordinateur de diagnostic (16) pouvant être relié aux fins de test - dans la mesure où cela est nécessaire - par un adaptateur d'interface (8) à l'unité électronique de commande (ECU) du véhicule, dispositif caractérisé en ce qu'il comprend en outre, une résistance de mesure (shunt) qui peut être montée seulement pour le test dans le chemin suivi par le courant (5, 6) entre la source de tension continue (2) et les récepteurs électriques (15) du véhicule et qu'on peut brancher après avoir enlevé le fusible principal (7), du véhicule aux bornes normalement prévues pour ce fusible principal (7), de façon qu'après activation du récepteur à tester par l'ordinateur de diagnostic (16), la résistance produise une chute de tension dépendant de la consommation de puissance du récepteur, chute qui est mesurée et comparée à une valeur de consigne spécifique du récepteur dans l'unité de diagnostic (8, 16) consistant en un ordinateur de diagnostic et - dans la mesure où cela est nécessaire - en un adaptateur d'interface, étant entendu que dans le cas où il apparaît une différence entre la valeur de consigne et la valeur réelle, l'amplitude de cette différence fournit une indication exacte constituant le résultat du test sur la détérioration existant concrètement dans le récepteur ou sur son défaut de fonctionnement, comme par exemple un court-circuit, une perte de tension au passage dans la pièce une panne totale, ou un court-circuit entre spires.

2. Dispositif selon la revendication 1, caractérisé en ce que la résistance de mesure (shunt) est conçue, avec un coefficient de résistance élevé.pour obtenir des valeurs de mesure hautement précises.

3. Dispositif selon l'une des revendications précédentes, caractérisé en ce que la résistance de mesure (shunt) forme une autre pièce constitutive autonome, en plus de la pièce constitutive autonome formée par l'ordinateur de diagnostic (16) et l'adaptateur d'interface (8) existant le cas échéant.

4. Dispositif selon l'une des revendications 1 et 2, caractérisé en ce que, si un adaptateur d'interface (8) forme l'une de ses parties constitutives, cet adaptateur, en plus de l'unité autonome formée par l'ordinateur de diagnostic (16) forme une autre unité autonome à laquelle la résistance de mesure (shunt) est branchée par construction, cette dernière unité constitutive présentant en outre indépendamment des raccords (K, L) de l'adaptateur d'interface (8) ceux (12, 13) de la résistance de mesure (shunt).
